**Europäisches Patentamt**

**European Patent Office**

**Office européen des brevets**

(19)

(11) Veröffentlichungsnummer: **0 465 709 A1**

# EUROPÄISCHE PATENTANMELDUNG

(12)

(21) Anmeldenummer: **90113326.4**

(22) Anmeldetag: **12.07.90**

(51) Int. Cl.⁵: **H03F 1/32**

(43) Veröffentlichungstag der Anmeldung:
**15.01.92 Patentblatt 92/03**

(84) Benannte Vertragsstaaten:
**AT BE CH DE DK ES FR GB GR LI LU NL SE**

(71) Anmelder: **ASEA BROWN BOVERI AG**
**Haselstrasse**
**CH-5401 Baden(CH)**

(72) Erfinder: **Puri, Narindra Nath, Dr.**
**45 Drinking Brook Rd.**
**South Brunswick(US)**
Erfinder: **Boksberger, Hans Ulrich**
**Spiracher 206**
**CH-5225 Oberbözberg(CH)**

(54) **Verfahren zur Kompensation von Nichtlinearitäten einer Verstärkerschaltung.**

(57) Die Anordnung betrifft ein Verfahren zur Kompensation von Nichtlinearitäten einer Verstärkerschaltung. Ein Eingangssignal s(t) wird unter Verwendung einer mit Nichtlinearitäten behafteten Verstärkerschaltung (2) (Leistungsverstärker) zu einem Ausgangssignal y(t) verstärkt. Der Verstärkerschaltung (2) wird ein Predistortion-Filter (1) vorgeschaltet. In diesem wird aus dem Eingangssignal s(t) und einem vom Ausgang des Predistortion-Filters rückgeführten, vorverzerrten Signal x(t) ein Summensignal

$$\dot{x}(t) = \frac{1}{k_0} \left\{ k_1 s(t) - \sum_{i=1}^{n} k_i x^i(t) \right\}$$

gebildet und zeitlich aufintegriert. Das vorverzerrte Signal x(t) wird der mit Nichtlinearitäten behafteten Verstärkerschaltung zugeführt. Die vorgegebene Zahl n + 1 von Koeffizienten $k_0$, ..., $k_n$ wird dabei entsprechend dem Modell

$$y(t) = k_0 \dot{x}(t) + \sum_{i=1}^{n} k_i x^i(t)$$

bestimmt, so dass bei einem gegebenen Eingangssignal x(t) der Verstärkerschaltung das gemäss dem Modell ermittelte Ausgangssignal mit dem Ausgangssignal y(t) der Verstärkerschaltung im wesentlichen übereinstimmt.

EP 0 465 709 A1

Fig. 1

## Technisches Gebiet

Die Erfindung betrifft ein Verfahren zur Kompensation von Nichtlinearitäten einer Verstärkerschaltung, bei welchem ein Eingangssignal s(t) unter Verwendung einer vorgegebenen, mit Nichtlinearitäten behafteten Verstärkerschaltung (z.B. Leistungsverstärker für Audiosignale) zu einem Ausgangssignal y(t) verstärkt wird.

## Stand der Technik

Verstärkerschaltungen, insbesondere Tonverstärker hoher Leistung, wie sie zur Modulation von Rundfunksendern im LW-, MW- und KW-Bereich eingesetzt werden, sind üblicherweise mit Nichtlinearitäten behaftet, die es zu eliminieren gilt. Die klassische Lösung zur Linearisierung der Charakteristik sieht eine Rückführung des Ausgangssignals vor (Feedback). Das Mass dieser Rückführung hängt von der Charakteristik des Verstärkers im nichtrückgekoppelten Zustand ab.

Aus der Regelungstechnik ist bekannt, wie bei linearen Verzerrungen einer Schaltung die Rückführung zu konzipieren ist, damit insgesamt eine lineare Charakteristik entsteht. Heutige nichtlineare Verstärkungsverfahren schliessen die lineare Rückführung oft aus regelungstechnischen Stabilitätsgründen aus. Die nicht vernachlässigbaren Signaldurchlaufzeiten können nämlich bei nicht durchdachter Rückführung das Verstärkungsverfahren instabil machen.

## Darstellung der Erfindung

Aufgabe der Erfindung ist es nun, ein Verfahren der eingangs genannten Art anzugeben, welches insbesondere für Audiosignale eine lineare Verstärkung unter Verwendung moderner Hochleistungsverstärker gewährleistet und frei von Instabilitäten ist.

Erfindungsgemäss besteht die Lösung darin, dass bei einem Verfahren der eingangs genannten Art

a) eine vorgegebene Zahl $n+1$ von Koeffizienten $k_0$, ..., $k_n$ der Verstärkerschaltung entsprechend dem Modell

$$y(t) = k_0 \dot{x}(t) + \sum_{i=1}^{n} k_i x^i(t)$$

bestimmt werden, so dass bei einem gegebenen Eingangssignal x(t) der Verstärkerschaltung das gemäss dem Modell ermittelte Ausgangssignal mit dem tatsächlichen Ausgangssignal y(t) der Verstärkerschaltung im wesentlichen übereinstimmt,

b) in einem Predistortion-Filter aus dem Eingangssignal s(t) und einem vom Ausgang des Predistortion-Filters rückgeführten, vorverzerrten Signal x(t) ein Summensignal

$$\dot{x}(t) = \frac{1}{k_0} \{ k_1 s(t) - \sum_{i=1}^{n} k_i x^i \} , \quad x(0) = s(0),$$

gebildet wird,

c) dieses Summensignal in einem Integrator zu einem vorverzerrten Signal x(t) zeitlich aufintegriert wird, und

d) das vorverzerrte Signal x(t) der mit Nichtlinearitäten behafteten Verstärkerschaltung zugeführt wird.

Der Kern der Erfindung besteht darin, dass die Charakteristik der Verstärkerschaltung, welche eine ausgeprägte Signaldurchlaufzeit und eine nichtlineare Amplitudenverstärkung aufweist, entsprechend dem Modell

$$y(t) = k_0\dot{x}(t) + \sum_{i=1}^{n} k_i x^i(t)$$

identifiziert wird und dass in einem vorgeschalteten Predistortion-Filter das Eingangssignal s(t) gemäss diesem Modell (d.h. den Koeffizienten $k_0$, $k_1$, $k_2$,..., $k_n$) so vorverzerrt wird, dass am Ausgang der Verstärkerschaltung ein linear verstärktes Ausgangssignal y(t) = $k_1$ s(t) vorliegt. Es wird also ein Kompensationssignal so erzeugt, dass insgesammt die unerwünschten Signalkomponenten ($k_0$, $k_2$, $k_3$,..., $k_n$) eliminiert werden.

Zwar wird das Ausgangssignal y(t) zur Korrektur von Nichtlinearitäten herangezogen, aber nicht im Sinn einer klassischen Rückführung. Dieser Ansatz bringt vom Prinzip her gewisse Vorteile, löst jedoch noch nicht alle Stabilitätsprobleme. Ein wichtiger Aspekt der Erfindung ist deshalb auch darin zu sehen, dass zur Vorverzerrung nur diejenigen Lösungsansätze des Modells herangezogen werden, die einen stabilen Betrieb gewährleisten. Mit anderen Worten, bei der Erfindung sind instabile Lösungen erkannt und gezielt eliminiert worden.

Die Grundidee der Erfindung kann mit gleichem Erfolg entweder mit analoger oder digitaler Schaltungstechnik verwirklicht werden. Während der oben formulierte Lösungsweg eher (auch wenn im Prinzip nicht ausschliesslich) der analogen Realisierung entspricht, ist der nachfolgende eindeutig der digitalen Formulierung angepasst.

Wie oben wird zunächst eine vorgegebene Zahl n + 1 von Koeffizienten $k_0$, ..., $k_n$ der Verstärkerschaltung entsprechend dem Modell

$$y(t) = k_0\dot{x}(t) + \sum_{i=1}^{n} k_i x^i(t)$$

bestimmt, so dass bei einem gegebenen Eingangssignal x(t) der Verstärkerschaltung das gemäss dem Modell ermittelte Ausgangssignal mit dem Ausgangssignal y(t) der Verstärkerschaltung im wesentlichen übereinstimmt. Das Predistortion-Filter arbeitet jedoch digital, das bedeutet, dass aus dem Eingangssignal s(t), falls es nicht schon in digitaler Form vorliegt (was in Zukunft sicher weitgehend der Fall sein wird), digitalisiert wird und dann aus dem digitalisierten Eingangssignal s(j) rekursiv ein Kompensationssignal c(j) gemäss

$$c(j+1) = \frac{-[k_2 s^2(j) + k_3 s^3(j) + k_0(N+1)\{s(j) - s(j-1)\}/2\pi]}{k_1 + 2k_2 s(j) + 3k_3 s^2(j)}$$
$$- \frac{[k_2 c^2(j) + k_3 c^3(j) + k_0(N+1)\{c(j) - c(j-1)\}/2\pi]}{k_1 + 2k_2 s(j) + 3k_3 s^2(j)}$$

gewonnen wird. Dieses Kompensationssignal wird zum Eingangssignal s(t) addiert. Das resultierende Signal x(t) wird in analoger (oder digitaler Form) der mit Nichtlinearitäten behafteten Verstärkerschaltung zugeführt.

Die Vorteile der digitalen gegenüber der analogen Lösung sind bekannt und kommen auch hier zur Geltung (keine Driftprobleme, einfache und flexible Implementation aufgrund der Programmierbarkeit etc.)

Die Bestimmung der Koeffizienten $k_0$, $k_1$, $k_2$, ..., $k_n$ kann entweder mit Hilfe spezieller Testsignale von Zeit zu Zeit oder kontinuierlich aufgrund z.B. des durchlaufenden Audiosignals vorgenommen werden. Es ist klar, dass ihr eine zentrale Bedeutung zukommt, kann doch im Endeffekt die Linearität der Verstärkung nur so gut sein wie die Schätzung der für die Predistortion verwendeten Koeffizienten.

Gemäss einer bevorzugten Ausführungsform der Erfindung wird zum Bestimmen der vorgegebenen Zahl n + 1 von Koeffizienten $k_0$, ..., $k_n$

a) in einem Identifikationsprozessor aus dem durch das Predistortion-Filter erzeugten vorverzerrten Signal x(t) entsprechend dem Modell der Verstärkerschaltung ein geschätztes Signal

$$\hat{u}(t) = k_0 \dot{x}(t) + \sum_{i=1}^{n} k_i x^i(t)$$

berechnet,

b) aus der Differenz zwischen diesem geschätzten Signal $\hat{u}(t)$ und dem Ausgangssignal y(t) der Verstärkerschaltung ein Fehlersignal e(t) gebildet und

c) aus dem vorverzerrten Signal x(t) und dem Fehlersignal e(t) die Koeffizienten $k_0$, ..., $k_n$ gemäss folgenden Regeln bestimmt:

$$\dot{k}_0 = \frac{1}{T\beta_0} \int_0^T e(t)\{\int x(t)dt\} \, dt$$

$$\dot{k}_i = \frac{1}{T\beta_i} \int_0^T e(t)x^i(t) \, dt \, , \, i = 1..n \, .$$

Für die digitale Implementation werden in einem Identifikationsprozessor aus dem vom Predistortion-Filter erzeugten vorverzerrten Signal x(t) und dem Ausgangssignal y(t) der Verstärkerschaltung die Koeffizienten $\underline{k} = [k_0, k_1, ..., k_n]^T$ gemäss

$$\underline{k} = G^{-1}\underline{r}$$

ermittelt. Die Definition dieser Grössen ergibt sich aus den weiter unten folgenden Erläuterungen. Es liegt auf der Hand, dass diese Lösung insbesondere im Zusammenhang mit der digitalen Predistortion vorteilhaft ist.

Einen anderen Weg beschreitet das nachfolgend beschriebene Identifikationsverfahren. Bei diesem werden

a) das vom Predistortion-Filter erzeugte vorverzerrte Signal x(t) und das Ausgangssignal y(t) der Verstärkerschaltung je einer schnellen Fouriertransoformation unterworfen und

b) in einem Identifikationsprozessor aus den fouriertransformierten Signalen die Koeffizienten $\underline{k} = [k_0, k_1, ..., k_n]^T$ gemäss

$$\underline{k} = (M^T M)^{-1} M^T \underline{Y}$$

bestimmt (ausführliche Definitionen folgen später).

Ein Kompensationssignal c(j) mit guter Konvergenz (Stabilität) lässt sich auch aus dem digitalisierten Eingangssignal s(j) gemäss

$$c(j+1) = \alpha \ [ \ c(j) - \{s(j+1)-s(j)\}$$

$$- \ \frac{k_2}{k_0} \ \frac{2\pi}{N} \ \{c(j)+s(j)\}^2$$

$$- \ \frac{k_2}{k_0} \ \frac{2\pi}{N} \ \{c(j)+s(j)\}^3 \ ]$$

$$\alpha = exp\{- \ \frac{k_1}{k_0} \ \frac{2\pi}{N} \ \} < 1$$

bestimmen.

Da bei der Verarbeitung von Audiosignalen in der Rundfunktechnik eine hohe Rechengeschwindigkeit gefordert ist, kommt der effizienten Berechnung der erfindungsgemässen Grössen eine gewisse Bedeutung zu. Vorteilhafterweise werden die Komponenten der Vektoren $\underline{r}(j)$, $\underline{k}(j)$ und der Matrizen $\overline{G}(j)$ aufdatiert gemäss folgendem Schema:

$r(j+1) = r(j) + \delta r(j+1)$
$\overline{G}(j+1) = \overline{G}(j) + \overline{\delta G}(j+1)$
$\underline{k}(j+1) = \underline{k}(j) + \delta \underline{k}(j+1)$ .

Eine für die Praxis der Sendertechnik gute Kompensation ergibt sich mit $n+1 = 4$ Koeffizienten $k_0$, ..., $k_3$. Damit wird mit akzeptablem Rechenaufwand eine gute Linearität der Verstärkung erreicht.

Besonders vorteilhaft ist es, wenn die Identifikation der Koeffizienten $k_i$, $i = 0..n$, in vorgegebenen zeitlichen Abständen während des Betriebs der Verstärkerschaltung durchgeführt wird. Dann ist eine adaptive Vorverzerrung möglich, die auch der sich im Betrieb verändernden Charakteristik des Leistungsverstärkers ständig Rechnung trägt.

Aus dem erfindungsgemässen Verfahren kann der Fachmann ohne weiteres eine geeignete Schaltandordnung ableiten. Die Erfindung umfasst somit auch eine Anordnung zum linearen Verstärken von Signalen, insbesondere für die Leistungsverstärkung von Audiosignalen, mit einer mit Nichtlinearitäten behafteten Verstärkerschaltung zum Erzeugen von Signalen hoher Leistung, welche Anordnung dadurch gekennzeichnet ist, dass

a) Mittel vorgesehen sind, um eine vorgegebene Zahl $n+1$ von Koeffizienten $k_0$, ..., $k_n$ der Verstärkerschaltung entsprechend dem Modell

$$y(t) = k_0 \dot{x}(t) + \sum_{i=1}^{n} k_i x^i(t)$$

bestimmt werden, so dass bei einem gegebenen Eingangssignal $x(t)$ der Verstärkerschaltung das gemäss dem Modell ermittelte Ausgangssignal mit dem Ausgangssignal $y(t)$ der Verstärkerschaltung im wesentlichen übereinstimmt,

b) vor der Verstärkerschaltung ein Predistortion-Filter vorgesehen ist, in welchem aus dem Eingangssignal $s(t)$ der Anordnung und einem vom Ausgang des Predistortion-Filters rückgeführten, vorverzerrten Signal $x(t)$ ein Summensignal

$$\dot{x}(t) = \frac{1}{k_0} \{k_1 s(t) - \sum_{i=1}^{n} k_i x^i(t) \}$$

gebildet wird, dieses Summensignal in einem Integrator zu einem vorverzerrten Signal x(t) zeitlich aufintegriert wird, und

c) das durch das Predistortion-Filter vorverzerrte Signal x(t) der mit Nichtlinearitäten behafteten Verstärkerschaltung zugeführt ist.

Dem Anwender der erfindungsgemässen Schaltung steht also insgesamt ein Hochleistungsverstärker mit linearer Charakteristik zur Verfügung. Das vorzugsweise digitale Predistortion-Filter lässt sich nämlich ohne weiteres im Gehäuse des fraglichen Leistungsverstärkers unterbringen.

Aus der Gesamtheit der abhängigen Patentansprüchen ergeben sich weitere vorteilhafte Ausführungsformen.

## Kurze Beschreibung der Zeichnungen

Nachfolgend soll die Erfindung anhand von Ausführungsbeispielen und im Zusammenhang mit den Zeichnungen näher erläutert werden. Es zeigen:

Fig. 1 ein Blockschaltbild eines Predistortion-Filters zur Linearisierung der Verstärkung einer nicht-linearen Verstärkerschaltung;

Fig. 2 ein Blockschaltbild eines Identifikationsprozessors zum Bestimmen der Koeffizienten $k_0$, ..., $k_n$;

Fig. 3 ein Blockschaltbild zur Durchführung der digitalen Identifikation; und

Fig. 4 ein Blockschaltbild zur Durchführung der Identifikation unter Verwendung der schnellen Fouriertransformation.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

## Wege zur Ausführung der Erfindung

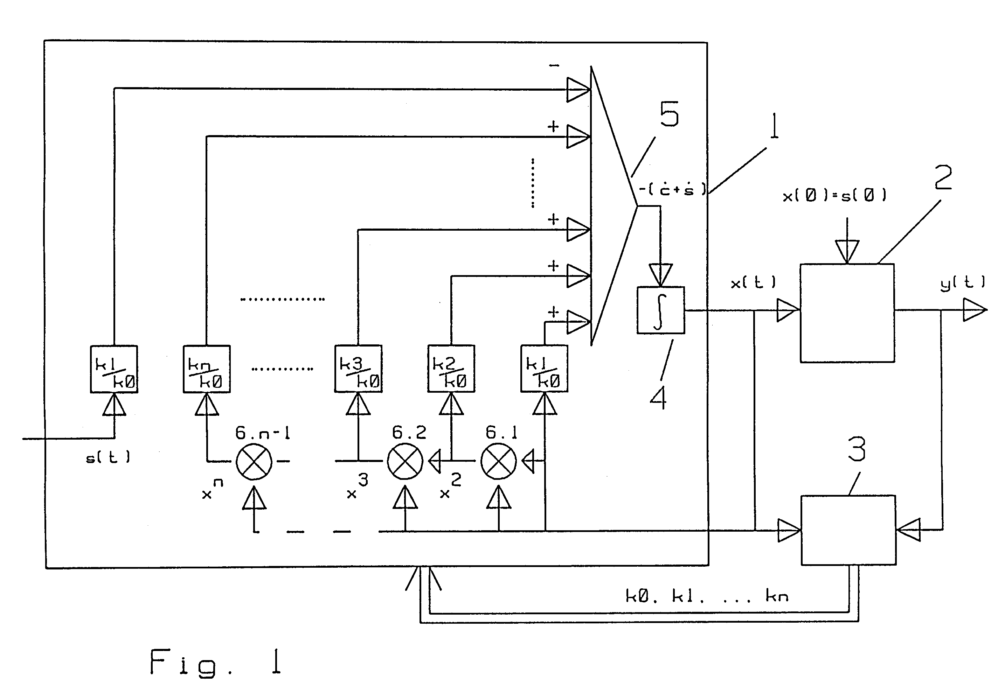

Fig. 1 zeigt ein Blockschaltbild eines Predistortion-Filters 1 zur Linearisierung der Verstärkung einer nicht-linearen Verstärkerschaltung 2. Ein Eingangssignal s(t), z.B. ein Audiosignal, soll linear verstärkt werden zu einem Ausgangssignal y(t):

(I)   $y(t) = k_1 s(t)$

Die vorgegebene Verstärkerschaltung 2, z.B. ein Hochleistungsverstärker, weist für sich eine nichtlineare Charakteristik auf. Typischerweise zeigt sie eine ausgeprägte Signaldurchlaufzeit und eine nichtlineare Amplitudenverstärkung. Dies hat zur Folge, dass Intermodulationen auftreten würden, wenn das Eingangssignal s(t) ohne irgendwelche Vorkehrungen direkt verstärkt würde.

Gemäss der Erfindung wird deshalb das Eingangssignal s(t) zunächst einem Predistortion-Filter 1 zugeführt, welches eine geeignete Vorverzerrung durchführt. Das vorverzerrte Signal x(t) wird sodann von der Verstärkerschaltung 2 auf das geforderte Leistungsniveau gebracht. Die Parameter der Vorverzerrung werden mit einem Identifikationsprozessor aus Ein- und Ausgangssignal der Verstärkerschaltung 2 gewonnen.

Die Art der Vorverzerrung stellt das wesentliche Merkmal der Erfindung dar. Sie soll im folgenden unter Berücksichtigung des mathematischen Hintergrundes eingehend erläutert werden.

Das der Erfindung zu Grunde liegende mathematische Modell der Verstärkerschaltung 2 ist folgendes:

(II)   $y(t) = k_0 \dot{x}(t) + \sum_{i=1}^{n} k_i x^i(t)$ ,   $\dot{x}(t) = \frac{d}{dt} x(t)$

(III)     x(t) = c(t) + s(t)

Zum Eingangssignal s(t) wird also ein Kompensationssignal c(t) addiert. Das resultierende vorverzerrte Signal x(t) wird entsprechend einer vorgegebenen Anzahl $n+1$ von Koeffizienten $k_0$, ..., $k_n$ in ein Ausgangssignal y(t) verstärkt. (Der "•" stellt in konventioneller Art die zeitliche Ableitung dar.)

Mit dem Koeffizient $k_0$ wird die Verzögerungszeit (delay time) des Verstärkerschaltung 2 identifiziert. Im übrigen sind die Koeffizienten $k_i$, $i = 0..n$, langsam veränderliche Parameter des Leistungsverstärkers, die sporadisch oder kontinuierlich bestimmt werden.

Die Koeffizienten $k_i$ sind gemäss der Erfindung so zu bestimmen, dass bei einem gegebenen Eingangssignal x(t) der Verstärkerschaltung 2 das gemäss dem Modell ermittelte Ausgangsingal mit dem Ausgangssignal y(t) der Verstärkerschaltung 2 im wesentlichen übereinstimmt. Allfällige Abweichungen sollten im optimalen Fall allein durch die Unzulänglichkeiten des Modells bedingt sein.

Die Bestimmung der Koeffizienten $k_i$ übernimmt im vorliegenden Ausführungsbeispiel ein Identifikationsprozessor 3. Er verwendet dazu das am Eingang der Verstärkerschaltung 2 direkt anliegende vorverzerrte Signal x(t) und das Ausgangssignal y(t). Die $n+1$ Koeffizienten $k_i$, $i = 0..n$, die er daraus berechnet, führt er an das Predistortion-Filter 1 zurück.

Predistortion-Filter:

Das Predistortion-Filter 1 beruht auf dem Prinzip, das Fehlersignal e(t) (IV)     $e(t) = y(t) - k_1 s(t)$

auf Null zu bringen. Dann entspricht nämlich das Ausgangssignal exakt dem linear verstärkten Eingangssignal.

Zu diesem Zweck wird aus dem Eingangssignal s(t) und dem vom Ausgang des Predistortion-Filters 1 rückgeführten, vorverzerrten Signal x(t) ein Summensignal

$$(V) \qquad \dot{x}(t) = \frac{1}{k_0}\{k_1 s(t) - \sum_{i=1}^{n} k_i x^i(t)\} \ , \ x(0) = s(0)$$

gebildet. Dieses Summensignal wird in einem Integrator 4 zum gewünschten vorverzerrten Signal x(t) zeitlich aufintegriert.

Fig. 1 zeigt eine mögliche Vorrichtung zum Durchführen der Vorverzerrung. Das Eingangssignal s(t) wird mit einem Faktor $k_1/k_0$ gewichtet einem Summierer 5 zugeführt. Aus dem vorzerzerrten Signal x(t) werden z.B. mit n-1 Multiplizierern 6.1, ..., 6.n-1 Potenzen $x^i(t)$, $i = 2..n$, gebildet, welche - gewichtet jeweils mit einem Faktor $k_i/k_0$, $i = 1..n$, - ebenfalls dem Summierer 5 zugeführt werden. Letzterer bildet das gewünschte Summensignal.

Die einzelnen Bauelemente dieser Schaltanordnung sind bekannt. Es ist für den Fachmann auch ohne weiteres möglich, eine Vorrichtung zur Durchführung der erfindungsgemässen Vorverzerrung (Formel (II) + (IV)) zu implementieren. Somit beschränkt sich die Erfindung auch nicht auf die dargestellte Ausführungsform der Schaltung.

Das Kompensationssignal c(t) kann mit Vorteil auf digitale Weise ermittelt werden. Zu diesem Zweck muss das Eingangssignal s(t) in digitalisierter Form, d.h. als Wertreihe s(j), j = 0, 1,... N, vorliegen. Gemäss der Erfindung ergibt sich c(j) aus der rekursiven Formel

$$(VI) \qquad c(j+1) = \frac{-[k_2 s^2(j)+k_3 s^3(j)+k_0(N+1)\{s(j)-s(j-1)\}/2\pi]}{k_1+2k_2 s(j)+3k_3 s^2(j)}$$

$$- \frac{[k_2 c^2(j)+k_3 c^3(j)+k_0(N+1)\{c(j)-c(j-1)\}/2\pi]}{k_1+2k_2 s(j)+3k_3 s^2(j)}$$

N bezeichnet die Zahl der Abtastwerte (samples) pro Rechenzyklus (j --> j + 1).

Dieses Kompensationssignal wird (auf analoger oder digitaler Ebene) zum Eingangssignal im Sinn der Formel (III) addiert. Das resultierende vorverzerrte Signal x(t) wird dann der mit Nichtlinearitäten behafteten Verstärkerschaltung zugeführt.

Ein Kompensationssignal c(j) mit guter Konvergenz (Stabilität) lässt sich aus dem digitalisierten Eingangssignal s(j) gemäss

$$(VII) \qquad c(j+1) = \alpha \, [ \, c(j) - \{s(j+1)-s(j)\}$$

$$- \frac{k_2}{k_0} \frac{2\pi}{N} \{c(j)+s(j)\}^2$$

$$- \frac{k_2}{k_0} \frac{2\pi}{N} \{c(j)+s(j)\}^3 \, ]$$

$$(VIII) \qquad \alpha = \exp\{- \frac{k_1}{k_0} \frac{2\pi}{N} \} \; < \; 1$$

bestimmen. Die Stabilität ist darin begründet, dass $\alpha < 1$ ist.

Identifikation:

Im Prinzip können die Koeffizienten $k_i$, i = 0..n, einmal bestimmt werden, z.B. bei der Inbetriebsetzung des Verstärkers, und dann als Konstanten für die Vorverzerrung benutzt werden. Vorzugsweise wird die Verstärkercharakteristik aber ständig von neuem identifiziert, so dass im Endeffekt eine adaptive Kompensation der Nichtlinearität resultiert. Insbesondere für diesen Fall gibt die Erfindung auch ein geeignetes Identifikationsverfahren an.

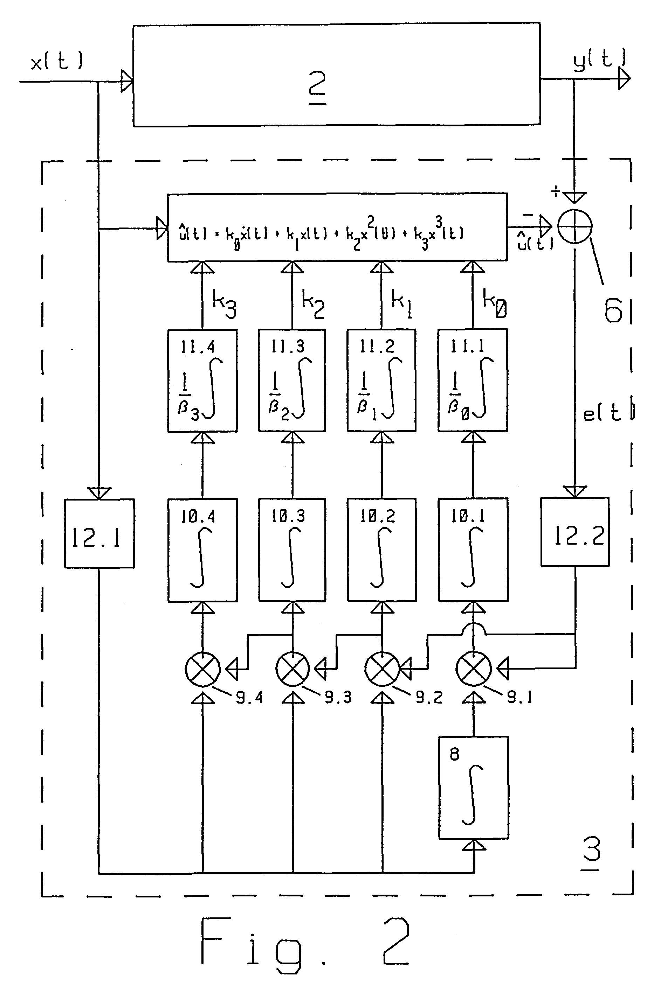

Das Prinzip der Identifikation geht aus Fig. 2 hervor. Das Verfahren arbeitet rekursiv. Um es in Gang zu setzen, müssen für die zu bestimmenden Koeffizienten $k_i$, i = 0..n, Anfangswerte vorgegeben werden. Auf diese Werte kommt es aber nicht wirklich an, da die Koeffizienten $k_i$, i = 0..n, in Regelfall (d.h. bei einigermassen vernünftigen Vorgaben, z.B. $|k1| >> |ki|$, i ≠ 1, d.h. i = 0, 2, 3, .., n) nach wenigen Durchläufen auf die gesuchten Werte hin konvergieren werden.

Mit den aus dem vorhergehenden Zyklus des Identifikationsdurchlaufes bekannten (oder zu Beginn vorgegebenen) Koeffizienten $k_i$, i = 0..n, wird ein entsprechend dem Modell der Verstärkerschaltung geschätztes Signal

$$(IX) \qquad \hat{u}(t) = k_0 \dot{x}(t) + \sum_{i=1}^{n} k_i x^i(t)$$

EP 0 465 709 A1

bestimmt. x(t) bezeichnet auch hier das unmittelbare Eingangssignal der Verstärkerschaltung, wobei es für die Identifikation nicht darauf ankommt, ob x(t) vorverzerrt worden ist oder nicht. Bei der adaptiven Kompensation ist das der Fall, beim Aufstarten des Predistortion-Filters in der Regel aber nicht.

Aus der Differenz zwischen diesem geschätzten Signal $\hat{u}(t)$ und dem Ausgangssignal y(t) der Verstärkerschaltung 2 wird ein Fehlersignal e(t)

$$(X) \qquad e(t) = y(t) - \hat{u}(t)$$

gebildet. Die Koeffizienten $k_i$, $i = 0..n$, werden aus dem unmittelbaren Eingangssignal x(t) und dem Fehlersignal e(t) gemäss folgenden Regeln gebildet:

$$(XI) \qquad k_0 = \frac{1}{\beta_0} \int \overline{e(t)\{\int x(t)dt\}} \; dt$$

$$(XII) \qquad k_i = \frac{1}{\beta_i} \int \overline{e(t)x^i(t)} \; dt \; , \quad i = 1..n.$$

In den Formeln bezeichnet der Ueberstrich in bekannter Weise die zeitliche Mittelung.

Die so errechneten Koeffizienten $k_i$, $i = 0..n$, werden für den nächsten Rechenzyklus für die Auswertung der Formel (IX) verwendet. Sie können auch an das Predistortion-Filter abgegeben werden. Bei der adaptiven Kompensation wird dies sicher der Fall sein. Bei nur sporadischer Bestimmung der Koeffizienten $k_i$, $i = 0..n$, wird z.B. abgewartet, bis das Identifikationsverfahren konvergiert hat.

Fig. 2 zeigt eine mögliche Vorrichtung zum Durchführen der Identifikation für $n+1=4$ Koeffizienten. Die Darstellung lehnt sich zwar eher an die Analogtechnik an, gilt aber gleichermassen für eine digitale Realisierung.

Ein Modellrechner 6 ermittelt das geschätzte Signal $\hat{u}(t)$ gemäss Formel (IX). Danach wird mit einem Differenzbildner 7 das Fehlersignal e(t) gemäss Formel (X) gebildet und in einem Filter 12.2 gefiltert.

Für jeden Koeffizienten $k_i$, $i = 0..3$ ist ein Signalpfad vorgesehen, welcher jeweils in Serie einen Multiplizierer 9.1,..,9.4, einen ersten Integrator 10.1,..,10.4 und einen mit einem Faktor $1/\beta_i$, $i = 0..3$, gewichteten zweiten Integrator 11.1, ..,11.4 aufweist. Dem für die Berechnung von $k_0$ vorgesehenen Pfad ist ein zusätzlicher Integrator 8 vorgeschaltet. Die Integratoren erzeugen im wesentlichen einen zeitlichen Mittelwert. Die Integrationsdauer in jedem Fall sollte grösser als eine Periode der kleinsten im Audiosignal auftretenden Frequenz sein ($Tf_{min} \gg 1$: Für Audiosignale z.B. gilt typischerweise $f_{min} = 50$ Hz --> z.B. T = 0.1 s).

Das Signal x(t) wird in einem Filter 12.1 gefilter und jedem Signalpfad zugeführt. Zur Berechnung von $k_0$ bildet der Multiplizierer 9.1 das Produkt zwischen e(t) und dem zeitlichen Mittelwert von x(t). Für die übrigen Koeffizienten $k_i$, $i = 1..3$, werden mit den Multiplizierern 9.2,..,9.4 die Produkte $x^i(t)e(t)$, $i = 1..3$, berechnet. Die genannten Produkte werden von den je nachfolgenden Integratoren 10.1 und 11.1 bis 10.4 und 11.4 gemittelt.

Die Gewichte $1/\beta_i$ ergeben sich optimalerweise aus den folgenden Beziehungen:

$$(XIII) \qquad \beta_0 \dot{k}_0 = \frac{1}{T} \int_0^T e(t)\{\int x(t)dt\} \; dt = \overline{e(t)\{\int x(t)dt\}}$$

$$(XIV) \qquad \beta_i \dot{k}_i = \frac{1}{T} \int_0^T e(t)x^i(t) \; dt = \overline{e(t)x^i(t)} \; , \quad i = 1..3$$

Wenn die Gewichte $1/\beta_i$ nicht entsprechend den Formeln definiert werden, dann konvergiert die Identifikation zwar nach wie vor, allerdings nicht mehr optimal schnell.

Die beiden Filter 12.1 und 12.2 lassen nur ein enges Frequenzband durch (Extraktion "einer" Fre-

10

quenz).

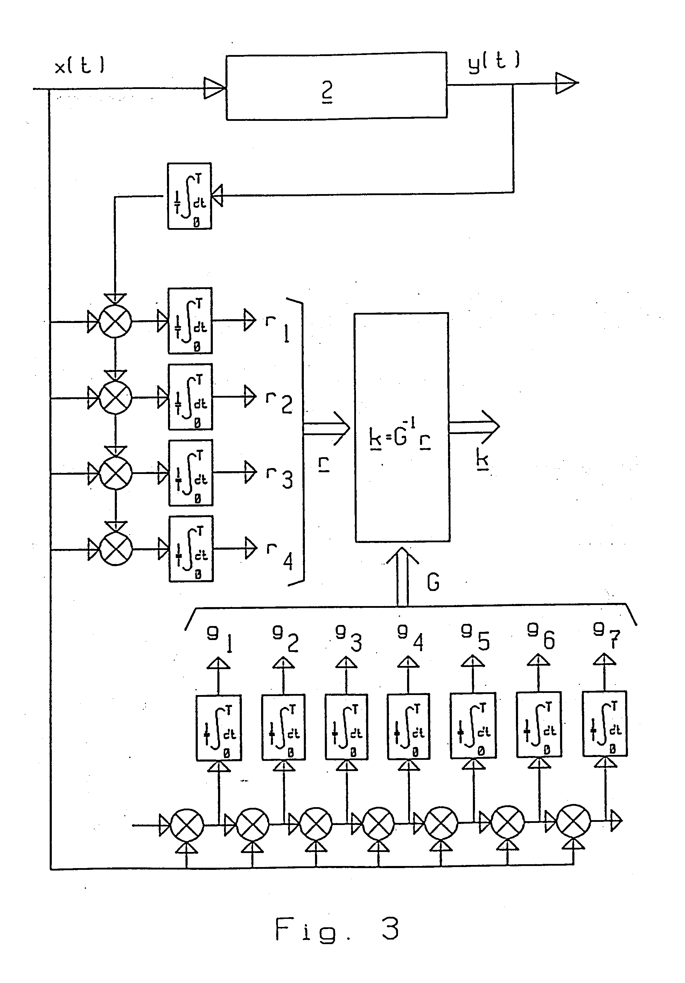

Fig. 3 zeigt ein Blockschaltbild eines Identifikationsprozessors, welches einer digitalen Realisierung der Erfindung entspricht. Das zugrunde liegende Verfahren funktioniert wie folgt.

Aus dem Ausgangssignal y(t) werden mit Hilfe von Multiplizierern und Integratoren 2n-1 verschiedene Koeffizienten einer (n + 1)(n + 1)-Matrix gebildet:

(XV)    $G = [G_{ik}]$ , i,k = 1..n + 1

$$(XVI) \qquad G_{ik} = g_{i+k-1} = \frac{1}{T} \int_0^T x^{i+k}(t)dt, \qquad i,k = 1..n+1$$

Zudem wird aus dem unmittelbaren Eingangssignal x(t) und dem Ausgangssignal y(t) der Verstärkerschaltung 2 ein (n + 1)-dimensionaler Vektor $\underline{r}$ ermittelt (das hochgestellte "T" bezeichnet dabei die Transposition):

(XVII)    $\underline{r} = [r_1, r_2, ..., r_{n+1}]^T$

$$(XVIII) \qquad r_i = \frac{1}{T} \int_0^T x^i(t)\{\int y(t)dt\} \ dt, \quad i = 1..n+1$$

Die Koeffizienten ki, i = 0..n, ergeben sich dann als Lösung der Gleichung

(XIX)    $\underline{k} = G^{-1}\underline{r}$

(XX)    $\underline{k} = [k_0, k_1, ..., k_n]^T$

Da bei der Verarbeitung von Audiosignalen in der Rundfunktechnik eine hohe Rechengeschwindigkeit gefordert ist, kommt der effizienten Berechnung der erfindungsgemässen Grössen eine gewisse Bedeutung zu. Vorteilhafterweise werden die Komponenten der Vektoren $\underline{r}(j)$, $\underline{k}(j)$ und der Matrizen G(j) aufdatiert gemäss folgendem Schema:

(XXI)    $\underline{r}(j + 1) = \underline{r}(j) + \delta\underline{r}(j + 1)$ ,

(XXII)    $\underline{G}(j + 1) = \underline{G}(j) + \delta\underline{G}(j + 1)$ ,

(XXIII)    $\underline{k}(j + 1) = \underline{k}(j) + \delta\underline{k}(j + 1)$ .

Die Komponenten dieser drei Vektoren werden also von einem Durchlauf zum nächsten abgespeichert. Mit dem Index j wird dabei zusätzlich der Durchlauf des Identifikationsverfahrens nummeriert:

$$(XXIV) \qquad r_i(j+1) = \frac{1}{T} \int_{jT}^{(j+1)T} x^i(t)y(t) \ dt \ , \quad i = 1..n+1$$

Analoges gilt für die anderen Grössen.
Eine gute Approximation bei der Berechnung des Koeffizientenvektors $\underline{k}(j)$ ist:

(XXV)    $\underline{k}(j + 1) = G^{-1}(j)[\delta\underline{r}(j + 1) - \delta\underline{G}(j + 1)\underline{k}(j)]$

11

oder

(XXVI)     $k_i(j+1) = \underline{G}^{-1}(j)\underline{r}(j) + \delta\underline{k}(j+1)$, i > 1


FFT-Identifikation

Ein anderer Weg wird mit der im folgenden beschriebenen Ausführungsform des Identifikationsverfahrens beschritten. Der wesentliche Unterschied besteht darin, dass die Identifikation der Koeffizienten $k_i$, i = 0..n, im Fourierraum erfolgt. Dieses Verfahren beruht vom Prinzip her nicht auf einer Rekursion.

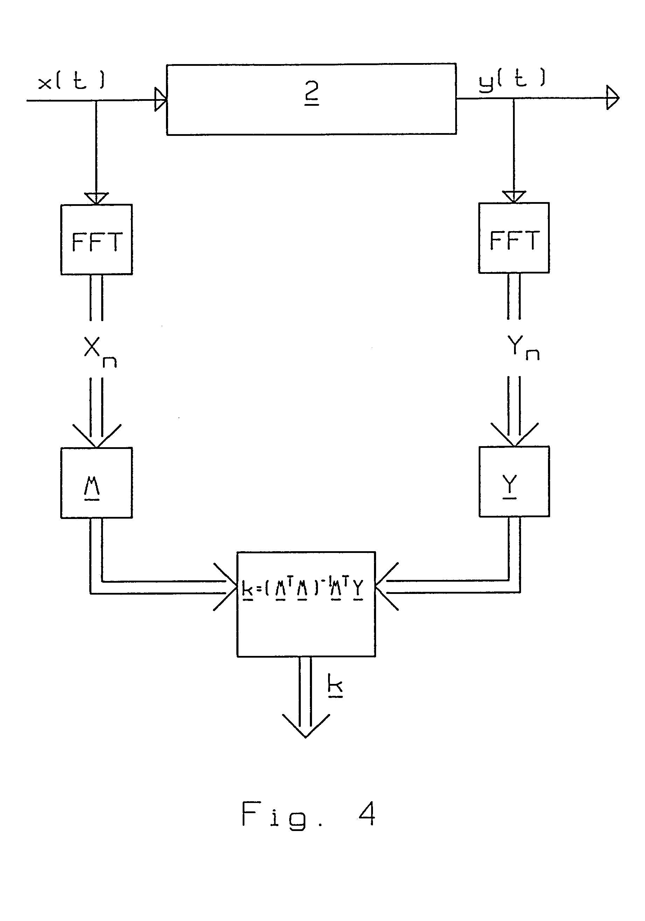

Fig. 4 zeigt ein Rechenbeispiel für n + 1 = 4 Koeffizienten $k_i$, i = 0..3, Als erstes werden das unmittelbare Eingangssignal x(t) (und dessen Potenzen $x^i(t)$) und das Ausgangssignal y(t) der Verstärkerschaltung einer schnellen Fouriertransformation (kurz FFT) unterworfen:

$$(XXVII) \quad T[x(t)] = \sum_{m=-N}^{N} X_m e^{jmwt}$$

$$(XXVIII) \quad T[x^2(t)] = \sum_{m=-N}^{N} A_m e^{jmwt}$$

$$(XXIX) \quad T[x^3(t)] = \sum_{m=-N}^{N} B_m e^{jmwt}$$

$$(XXX) \quad A_m = \sum_{i=-N}^{N} X_m X_{m-i}$$

$$(XXXI) \quad B_m = \sum_{i=-N}^{N} A_m X_{m-i}$$

$$(XXXII) \quad T[y(t)] = \sum_{m=-N}^{N} Y_m e^{jmwt}$$

w =     Grundfrequenz der FFT
N =     Anzahl Frequenzen der FFT
j =     komplexe Einheit ($e^{j\pi}$ = -1)

$T[\bullet]$ symbolisiert die FFT-Reihe, welche höchstens Nw Frequenzen umfasst. Bei $T[x^3(t)]$ beispielsweise werden also alle Frequenzen grösser als Nw weggelassen. Es ist zu beachten, dass $X_m$, $A_m$, $B_m$ und $Y_m$ im allgemeinen komplexwertige Koeffizienten sind.

Die Anwendung der FFT auf Formel (II) - wobei n = 3 gesetzt ist - und der Koeffizientenvergleich führt zu folgender Gleichung:

(XXXIII)     $Y_m = (-jmwX_m)k_0 + X_m k1 + A_m k2 + B_m k_3$ , m = 0..N

12

Gemäss der Erfindung wird nun diese Gleichung ausgewertet. Um eine einfache Darstellung der Lösung zu erhalten, wird die Vektornotation eingeführt. Im einzelnen werden folgende Grössen definiert:

(XXXIV)   $\underline{Y} = [\underline{Y}_1, \underline{Y}_2]^T$

(XXXV)   $\underline{Y}_i = [Y_{i0}, Y_{i1}, ..., Y_{iN}]^T$ , i = 1, 2

(XXXVI)   $Y_{1m} = -mwX_{2m}k_0 + X_{1m}k_1 + A_{1m}k_2 + B_{1m}k_3$, m = 0..N

(XXXVII)   $Y_{2m} = mwX_{1m}k_0 + X_{2m}k_1 + A_{2m}k_2 + B_{2m}k_3$, m = 0..N

(XXXVIII)   $Y_m = Y_{1m} + jY_{2m}$ , m = 0..N

(XXXIX)   $X_m = X_{1m} + jX_{2m}$ , m = 0..N

(XL)   $A_m = A_{1m} + jA_{2m}$ , m = 0..N

(XLI)   $B_m = B_{1m} + jB_{2m}$ , m = 0..N

Die Grössen $Y_{1m}$, $Y_{2m}$, $X_{1m}$, $X_{2m}$, $A_{1m}$, $A_{2m}$, $B_{1m}$ und $B_{2m}$ (m = 0..N) sind also gewöhnliche reelle Zahlen. Mit den folgenden Matrixdefinitionen:

(XLII)   $M = [M_1, M_2]^T$

$$(XLIII) \quad M_1 = \begin{matrix} 0 & X_{10} & A_{10} & B_{10} \\ -wX_{21} & X_{11} & A_{11} & B_{11} \\ \cdot & \cdot & \cdot & \cdot \\ \cdot & \cdot & \cdot & \cdot \\ -wX_{N1} & X_{1N} & A_{1N} & B_{1N} \end{matrix}$$

$$(XLIV) \quad M_2 = \begin{matrix} 0 & X_{20} & A_{20} & B_{20} \\ wX_{11} & X_{21} & A_{21} & B_{21} \\ \cdot & \cdot & \cdot & \cdot \\ \cdot & \cdot & \cdot & \cdot \\ wX_{1N} & X_{2N} & A_{2N} & B_{2N} \end{matrix}$$

kann die erfindungsgemässe Lösung auf die einfache Formel

(XLV)   $\underline{k} = (M^TM)^{-1}M^T\underline{Y}$

(XLVI)   $\underline{k} = [k_0, k_1, k_2, k_3]^T$

gebracht werden.

Das Identifikationsverfahren umfasst also folgende Schritte:

1. Mit Hilfe der FFT die Koeffizienten $Y_{1m}$, $Y_{2m}$, $X_{1m}$, $X_{2m}$, $A_{1m}$, $A_{2m}$, $B_{1m}$ und $B_{2m}$ (m = 0..N) bestimmen.

2. Aus diesen Koeffizienten die Matrix M resp. $(M^TM)^{-1}$ bilden.

3. Die Koeffizienten $k_i$, i = 0..3, aus Gleichung (XLV) berechnen.

Das soeben erläuterte Ausführungsbeispiel bezieht sich zwar auf n + 1 = 4, für den Fachmann ist damit jedoch klar, wie er das erfindungsgemässe Verfahren für andere n auszubilden hat. Für n + 1 = 5 beispielsweise wären weitere Koeffizienten $C_m$ gemäss

$$(XLVII) \qquad C_m = \sum_{i=-N}^{N} B_m X_{m-i}$$

zu bilden. Entsprechend vergrössert sich die Matrix M.

Abschliessend kann festgestellt werden, dass die Erfindung die Linearisierung von nichtlinearen Kennlinien ermöglicht, wie sie insbesondere bei Hochleistungsverstärkern in der Nachrichtentechnik benötigt werden.

**Bezeichnungsliste**

1 - Predistortion-Filter; 2 - Verstärkerschaltung; 3 - Identifikationsprozessor; 4 - Integrator; 5 - Summierer; 6 - Modellrechner; 7 - Differenzbildner; 8 - Integrator; 9.1,..,9.4 - Multiplizierer; 10.1,..,10.4, 11.1,..,11.4 - Integrator; 12.1, 12.2 - Filter; c(t) - Kompensationssignal; e(t) - Fehlersignal; s(t) - Eingangssignal; x(t) - vorverzerrte Signal; y(t) - Ausgangssignal.

**Patentansprüche**

1. Verfahren zur Kompensation von Nichtlinearitäten einer Verstärkerschaltung, bei welchem ein Eingangssignal s(t) unter Verwendung einer vorgegebenen, mit Nichtlinearitäten behafteten Verstärkerschaltung zu einem Ausgangssignal y(t) verstärkt wird, dadurch gekennzeichnet, dass
   a) eine vorgegebene Zahl $n+1$ von Koeffizienten $k_0$, ..., $k_n$ der Verstärkerschaltung entsprechend dem Modell

$$y(t) = k_0 \dot{x}(t) + \sum_{i=1}^{n} k_i x^i(t)$$

   bestimmt werden, so dass bei einem gegebenen Eingangssignal x(t) der Verstärkerschaltung das gemäss dem Modell ermittelte Ausgangssingal mit dem tatsächlichen Ausgangssignal y(t) der Verstärkerschaltung im wesentlichen übereinstimmt,
   b) in einem Predistortion-Filter aus dem Eingangssignal s(t) und einem vom Ausgang des Predistortion-Filters rückgeführten, vorverzerrten Signal x(t) ein Summensignal

$$\dot{x}(t) = \frac{1}{k_0} \{ k_1 s(t) - \sum_{i=1}^{n} k_i x^i(t) \} , \quad x(0) = s(0)$$

   gebildet wird,
   c) dieses Summensignal in einem Integrator zu einem vorverzerrten Signal x(t) zeitlich aufintegriert wird, und
   d) das vorverzerrte Signal x(t) der mit Nichtlinearitäten behafteten Verstärkerschaltung zugeführt wird.

2. Verfahren zur Kompensation von Nichtlinearitäten einer Verstärkerschaltung, bei welchem ein Eingangssignal s(t) unter Verwendung einer mit Nichtlinearitäten behafteten Verstärkerschaltung zu einem Ausgangssignal y(t) verstärkt wird, dadurch gekennzeichnet, dass
   a) eine vorgegebene Zahl $n+1$ von Koeffizienten $k_0$, ..., $k_n$ der Verstärkerschaltung entsprechend dem Modell

$$y(t) = k_0 \dot{x}(t) + \sum_{i=1}^{n} k_i x^i(t)$$

bestimmt werden, so dass bei einem gegebenen Eingangssignal x(t) der Verstärkerschaltung das gemäss dem Modell ermittelte Ausgangssignal mit dem tatsächlichen Ausgangssignal y(t) der Verstärkerschaltung im wesentlichen übereinstimmt,

b) in einem Predistortion-Filter aus dem digitalisierten Eingangssignal s(j) ein Kompensationssignal c(j) gemäss

$$c(j+1) = \frac{-[k_2 s^2(j) + k_3 s^3(j) + k_0(N+1)\{s(j)-s(j-1)\}/2\pi]}{k_1 + 2k_2 s(j) + 3k_3 s^2(j)}$$

$$- \frac{[k_2 c^2(j) + k_3 c^3(j) + k_0(N+1)\{c(j)-c(j-1)\}/2\pi]}{k_1 + 2k_2 s(j) + 3k_3 s^2(j)}$$

c) dieses Kompensationssignal zum Eingangssignal addiert wird, und

d) das resultierende Signal x(t) der mit Nichtlinearitäten behafteten Verstärkerschaltung zugeführt wird.

3. Verfahren nach Anspruch 1 oder 2, dadurch gekennzeichnet, dass zum Bestimmen der vorgegebenen Zahl $n+1$ von Koeffizienten $k_0, ..., k_n$

a) in einem Identifikationsprozessor aus dem unmittelbaren Eingangssignal x(t) der nichtlinearen Verstärkerschaltung entsprechend dem Modell der Verstärkerschaltung ein geschätztes Signal

$$\hat{u}(t) = k_0 \dot{x}(t) + \sum_{i=1}^{n} k_i x^i(t)$$

bestimmt wird,

b) aus der Differenz zwischen diesem geschätzten Signal û(t) und dem tatsächlichen Ausgangssignal y(t) der Verstärkerschaltung ein Fehlersignal e(t) gebildet wird, und

c) aus dem genannten Eingangssignal x(t) und dem Fehlersignal e(t) die Koeffizienten $k_0, ..., k_n$ gemäss folgenden Regeln gebildet werden:

$$\dot{k}_0 = \frac{1}{T\beta_0} \int_0^T e(t)\{\int x(t)dt\} \, dt$$

$$\dot{k}_i = \frac{1}{T\beta_i} \int_0^T e(t)x^i(t) \, dt \, , \, i = 1..n \, .$$

4. Verfahren nach Anspruch 1 oder 2, dadurch gekennzeichnet, dass in einem Identifikationsprozessor aus dem unmittelbaren Eingangssignal x(t) der nichtlinearen Verstärkerschaltung und dem tatsächlichen Ausgangssignal y(t) der Verstärkerschaltung die Koeffizienten $\underline{k} = [k_0, k_1, ..., k_n]^T$ gemäss

$$\underline{k} = G^{-1}\underline{r}$$

bestimmt werden.

5. Verfahren nach Anspruch 1 oder 2, dadurch gekennzeichnet, dass
   a) das unmittelbare Eingangssignal x(t) der nichtlinearen Verstärkerschaltung und das Ausgangssignal y(t) je einer schnellen Fouriertransoformation unterworfen werden und
   b) in einem Identifikationsprozessor aus den fouriertransformierten Signalen die Koeffizienten $\underline{k}$ = $[k_0, k_1, ..., k_n]^T$ gemäss

   $$\underline{k} = (M^TM)^{-1}M^T\underline{Y}$$

   bestimmt werden.

6. Verfahren nach Anspruch 2, dadurch gekennzeichnet, dass in Abweichung zu Anspruch 2 das Kompensationssignal c(j) aus dem digitalisierten Eingangssignal s(j) gemäss

   $$c(j+1) = \alpha \left[ c(j) - \{s(j+1)-s(j)\} \right.$$

   $$- \frac{k_2}{k_0} \frac{2\pi}{N} \{c(j)+s(j)\}^2$$

   $$\left. - \frac{k_2}{k_0} \frac{2\pi}{N} \{c(j)+s(j)\}^3 \right]$$

   $$\alpha = \exp\{- \frac{k_1}{k_0} \frac{2\pi}{N} \} < 1$$

   ermittelt wird.

7. Verfahren nach Anspruch 4, dadurch gekennzeichnet, dass die Komponenten der Vektoren $\underline{r}(j)$, $\underline{k}(j)$ und der Matrizen G(j) aufdatiert werden gemäss

   $$\underline{r}(j+1) = \underline{r}(j) + \delta\underline{r}(j+1)$$
   $$G(j+1) = G(j) + \delta G(j+1)$$
   $$\underline{k}(j+1) = \underline{k}(j) + \delta\underline{k}(j+1).$$

8. Verfahren nach Anspruch 1 oder 2, dadurch gekennzeichnet, dass das Predistortion-Filter mit n + 1 = 4 Koeffizienten $k_0, ..., k_3$ arbeitet.

9. Verfahren nach Anspruch 1, dadurch gekennzeichnet, dass die Koeffizienten $k_0, ..., k_n$ ständig neu bestimmt werden, so dass adaptive Kompensation der Nichtlinearitäten resultiert.

10. Anordnung zum linearen Verstärken von Signalen, insbesondere für die Leistungsverstärkung von Audiosignalen, umfassend eine mit Nichtlinearitäten behaftete Verstärkerschaltung zum Erzeugen von Signalen hoher Leistung, dadurch gekennzeichnet, dass
    a) erste Mittel vorgesehen sind, um eine vorgegebene Zahl n + 1 von Koeffizienten $k_0, ..., k_n$ der Verstärkerschaltung entsprechend dem Modell

16

$$y(t) = k_0 \dot{x}(t) + \sum_{i=1}^{n} k_i x^i(t)$$

bestimmt werden, so dass bei einem gegebenen Eingangssignal x(t) der Verstärkerschaltung das gemäss dem Modell ermittelte Ausgangssingal mit dem Ausgangssignal y(t) der Verstärkerschaltung im wesentlichen übereinstimmt,

b) vor der Verstärkerschaltung ein Predistortion-Filter vorgesehen ist, in welchem aus dem Eingangssignal s(t) der Anordnung und einem vom Ausgang des Predistortion-Filters rückgeführten, vorverzerrten Signal x(t) ein Summensignal

$$\dot{x}(t) = \frac{1}{k_0} \{ k_1 s(t) - \sum_{i=1}^{n} k_i x^i(t) \} \; , \; x(0) = s(0)$$

gebildet wird, dieses Summensignal in einem Integrator zu einem vorverzerrten Signal x(t) zeitlich aufintegriert wird, und

c) das durch das Predistortion-Filter vorverzerrte Signal x(t) der mit Nichtlinearitäten behafteten Verstärkerschaltung zugeführt ist.

Fig. 1

$$\hat{u}(t) = k_0 \dot{x}(t) + k_1 x(t) + k_2 x^2(t) + k_3 x^3(t)$$

Fig. 2

Fig. 3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 361 608  (LABORATOIRES D'ELECTRONIQUE PHILIPS)<br>* Figur 5; Zusammenfassung *<br>– – – | 1,10 | H 03 F 1/32 |
| A | DE-C-3 221 911  (STANDARD ELEKTRIK LORENZ)<br>* Figur 1; Spalte 4, Zeilen 2-21 *<br>– – – | 1,10 | |
| A | GB-A-2 173 074  (NEC CORP.)<br>* Figur 6; Seite 1, Zeilen 27-100 *<br>– – – | | |
| A | PATENT ABSTRACTS OF JAPAN vol. 7, no. 208 (E-198)(1353), 14. September 1983;<br>& JP - A - 58105658 (NIPPON DENKI) 23.06.1983<br>– – – – – | | |

| | | | RECHERCHIERTE SACHGEBIETE (Int. Cl.5) |
|---|---|---|---|
| | | | H 03 F<br>H 04 B |

Der vorliegende Recherchenbericht wurde für alle Patentansprüche erstellt

| Recherchenort | Abschlußdatum der Recherche | Prüfer |
|---|---|---|
| Berlin | 08 Februar 91 | BREUSING J |